# FASCICULE DE BREVET EUROPEEN

(11) **EP 0 627 765 B1**
(45) Date de publication et mention de la délivrance du brevet: **30.09.1998**
(21) Numéro de dépôt: 94201343.4
(22) Date de dépôt: 11.05.1994
(51) Int. Cl.: H01L 23/48, H01L 23/66

(54) **Dispositif semiconducteur incluant un élément semiconducteur du type "FLIP-CHIP"**
Halbleiteranordnung mit einem Halbleiterelement von Flip-Chip-Typ
Semiconductor device having a flip-chip semiconducteur element

(30) Priorité: 18.05.1993 FR 9305996
(43) Date de publication de la demande: 07.12.1994
(73) Titulaire: LABORATOIRES D'ELECTRONIQUE PHILIPS S.A.S., 94450 Limeil-Brévannes (FR); Koninklijke Philips Electronics N.V., 5621 BA Eindhoven (NL)
(72) Inventeur: Gamand, Patrice, Société Civile S.P.I.D., F-75008 Paris (FR)
(74) Mandataire: Lottin, Claudine

(56) Documents cités:
- EP-A- 0 098 167
- EP-A- 0 436 912
- EP-A- 0 469 988
- US-A- 4 992 764
- US-A- 5 156 998

## Description

L'invention concerne un dispositif semiconducteur hyperfréquences comportant :
- un élément semiconducteur du type "FLIP-CHIP", lequel comprend un substrat semiconducteur dont une face dite active a au moins un circuit intégré et une pluralité de plots métalliques d'entrées-sorties,
- une carte de base, laquelle comprend un substrat isolant dont une face dite avant a une pluralité de plots métalliques d'entrées-sorties,
- et des moyens de fixation de la face active de l'élément semiconducteur sur la face avant de la carte de base, avec les plots correspondants d'entrées-sorties en contact électrique.

Par élément semiconducteur du type FLIP-CHIP, il faut entendre un élément comprenant un substrat semiconducteur dont une face dite active comporte un circuit intégré et des plots d'entrées-sorties et est fixée sur la face avant d'un support isolant, appelé carte de base, ayant des plots d'entrées-sorties en correspondance.

Dans l'agencement "FLIP-CHIP", le substrat semiconducteur est "retourné" lors de sa fixation sur la carte de base, pour que sa face active soit en regard de la face avant de la carte de base, et pour que sa face opposée à la face active devienne la face supérieure du dispositif semiconducteur. L'avantage est que les plots d'entrées-sorties de l'élément semiconducteur viennent directement en coïncidence avec ceux de la carte de base et que les fils de connexion soudés sont évités.

L'invention trouve par exemple son application dans la réalisation de boîtiers pour des circuits hyperfréquences dans le domaine de 10 à 120 GHz.

Un dispositif semiconducteur tel que décrit dans le préambule est déjà connu de l'état de la technique par la demande de brevet européen publiée sous le N° EP 0469 614 A1.

Le dispositif connu comprend un élément semiconducteur formé d'un substrat avec une face avant active portant un circuit intégré (en anglais CHIP). Cette face active porte également une pluralité de plots de contact pour les entrées-sorties du circuit intégré. Ce dispositif comprend en outre une carte de base formée d'un substrat avec une face avant servant de support pour l'élément semiconducteur et portant à cet effet une pluralité de plots de contact. Selon le document cité, pour connecter électriquement l'élément semiconducteur avec la carte de base, cet élément semiconducteur est "retourné" (en anglais FLIP) avec sa face active dirigée vers la face avant de la carte de base, et les dessins des plots de contact des deux faces en regard sont prévus en coïncidence. Lorsque les plots de la face active de l'élément semiconducteur retourné sont en coïncidence avec les plots de la face avant de la carte de base, des moyens de scellement sont fournis de manière à obtenir la connexion électrique entre les plots de contact respectifs de l'élément semiconducteur et de la carte de base.

Dans le domaine des hyperfréquences, il faut d'abord prendre en compte que toutes les connexions sont des lignes de transmission. Le problème se pose donc dans un circuit donné d'intégrer les éléments actifs (transistors et diodes) et passifs (résistances, capacités, selfs inductances et lignes de transmission hyperfréquences) sur une même puce. D'autre part, dans ce domaine de fréquences, il est apparu nécessaire pour des raisons à la fois techniques et économiques d'intégrer sur la même puce, avec le circuit actif, un ou plusieurs circuits purement passifs formés de lignes de transmissions. Ces circuits passifs ont des grandes dimensions. Par exemple, à 12 GHz, un tel circuit du type déphaseur 90° ou 180° aura des éléments de lignes de transmission de dimensions supérieures au quart de la longueur d'onde guidée, qui est alors de 9 mm, soit 2,25 mm. Donc l'utilisation de tels éléments passifs associés à des éléments actifs conduit à des aires de circuits intégrés non compatibles avec les aires des substrats disponibles en production, ou n'impliquant pas des coûts suffisamment faibles pour déboucher sur des dispositifs industriellement compétitifs.

Les circuits hyperfréquences qui comprennent plusieurs sous-ensemble intégrés sur une même puce sont appelés circuits monolithiques (en anglais MMICs = Monolithic Microwave Integrated Circuits). Pour les différentes raisons exposées ici, cette intégration monolithique est souvent difficile.

Dans le domaine des hyperfréquences, se posent parallèlement au problème de surface cité plus haut plusieurs autres problèmes relatifs à l'intégration monolithique.

Un de ces problèmes concerne la limitation en fréquences qui apparaît si les lignes de transmission sont soumises à l'influence d'éléments indésirables. Ces éléments indésirables qui perturbent les conditions de propagation des ondes millimétriques dans les lignes peuvent êtres constitués notamment par la proximité du plan de matériau diélectrique de la face avant de la carte de base, lors de la fixation de l'élément semiconducteur sur cette dernière, ou bien par la proximité du matériau de fixation lui-même, du fait que le circuit de lignes est disposé en regard de cette face avant : ou bien par la proximité d'autres sous-ensembles du cirucit monolithique. La disposition de lignes de transmission dans cette situation de proximité d'un diélectrique étranger à leur structure, ou d'un élément rayonnant, doit être évitée pour tout circuit dont les signaux sont très sensibles aux dimensions et structures des lignes. Ceci est le cas en particulier pour les circuits déphaseurs de 90°, ou déphaseurs de 180° cités précédemment.

Un autre de ces problèmes concerne la limitation en fréquences qui apparaît s'il existe des discontinuités dans le raccordement des masses.

Un autre de ces problèmes concerne l'apparition de capacités parasites si les connexions entre les conducteurs hyperfréquences sont imparfaites.

Un but de l'invention est donc de proposer un tel dispositif hyperfréquences ayant, outre un circuit intégré hyperfréquences réalisé sur une face active d'un puce, au moins un circuit passif de lignes hyperfréquences, ceci sans augmentation de l'aire du substrat nécessaire à la réalisation de la puce.

Un autre but de l'invention est de proposer un tel dispositif dans lequel le circuit est dépourvu de discontinuités dans le raccordement des masses.

Ces buts sont atteints au moyen du dispositif semiconducteur défini dans le préambule et en outre caractérisé en ce que :
- l'élément semiconducteur comprend, d'une part un circuit de lignes de transmission du type coplanaire dont les rubans conducteurs et les métallisations de masse sont disposés sur la face active, et d'autre part un circuit de lignes de transmission du type microruban, dont les rubans conducteurs sont disposés sur la face opposée à la face active, et dont les métallisations de masse sont constituées par celles de la face active,
- la carte de base comprend en outre des métallisations de masse dessinées de manière à être en contact électrique avec les métallisations de masse de la face active de l'élément semiconducteur lors de la fixation de ce dernier sur la carte de base.

Un avantage du dispositif selon l'invention réside dans le fait que les dimensions du substrat nécessaire pour réaliser un circuit monolithique hyperfréquences comprenant des régions de circuits actifs et des régions de circuit passifs de grande surface, peuvent être réduites par deux par rapport aux dimensions qui seraient nécessaires si le procédé connu de l'état de la technique était utilisé. La réalisation d'un circuit intégré monolithique est donc facilitée.

Un autre avantage réside dans le fait que les régions de circuits passifs où se fait principalement la propagation et qui sont sensibles aux perturbations engendrées par la fixation de l'élément semiconducteur sur la carte de base, peuvent être réalisées sur la face opposée à la face active : ces perturbations sont donc évitées, et les performances du circuit monolithique sont améliorées.

Un autre avantage réside dans le fait qu'il n'existe pas de discontinuités dans les plans de masse : sur l'élément semiconducteur, les plans de masse des deux faces sont communs ; et lors de la fixation de l'élément semiconducteur sur la carte de base, les plans de masse du premier sont appliqués sur les plans de masse de la seconde qui se trouvent en regard et connectés électriquement. Ceci est également un élément d'amélioration des performances du circuit monolithique.

Un autre but de l'invention est de proposer un tel dispositif dans lequel les capacités parasites dues à l'imperfection des connexions hyperfréquences sont diminuées.

A cet effet, dans une forme de réalisation, ce dispositif semiconducteur est caractérisé en ce que l'élément semiconducteur comprend des trous métallisés pour connecter les circuits et/ou plots de la face active avec le circuit de la face opposée.

Un avantage de cette forme de réalisation est qu'il n'est pas nécessaire d'utiliser, pour réaliser certaines connexions hyperfréquences, des fils métalliques fins soudés, comme il est généralement connu de l'homme du métier. Ces fils fins sont générateurs de capacités parasites. Ainsi selon l'invention, un circuit peut être réalisé sur la face opposée à la face de fixation, sans perdre l' avantage de la technique "FLIP-CHIP". Ceci améliore également les performances du circuit monolithique.

L'invention est décrite ci-après en détail en référence avec les figures schématiques annexées dont :
- la FIG.1A est une vue du dessus d'une ligne de transmission d'un circuit intégré en technologie microruban ;
- la FIG.1B est une vue en coupe de cette ligne, selon l'axe B-B ;
- la FIG.2A est une vue du dessus d'une ligne de transmission d'un circuit intégré en technologie coplanaire,
- la FIG.2B est une vue en coupe de cette ligne, selon l'axe B-B ;
- la FIG.3A représente un exemple de circuit hyperfréquences réalisable monolithiquement dans un dispositif selon l'invention ;
- la FIG.3B représente en vue plane, une mise en oeuvre du circuit de la FIG.3A, avec le sous-ensemble actif et un sous-ensemble passif disposés sur la face active de l'élément semiconducteur et avec un second sous-ensemble passif réalisé sur la face opposée ;
- la FIG.3C représente vu du dessus un exemple de circuit réalisable sur la face avant de la carte de base pour recevoir l'élément semiconducteur de la FIG.3B ;
- la FIG.4A est une vue de l'élément semiconducteur du dispositif de la FIG.3B en coupe selon I-I ;
- la FIG.4B est une vue du dispositif de la FIG.3B en coupe selon I-I, dans laquelle l'élément semiconducteur de la FIG.4A est monté sur la carte, avec sa face active retournée vers la face avant de la carte de base,
- la FIG.4C est une vue du dispositif de la FIG.3B, en coupe selon J-J, dans laquelle l'élément semiconducteur est monté sur la carte de base avec sa face active tournée vers la face avant de la carte de base ;
- la FIG.4D est une vue du dispositif de la FIG.3B, en coupe selon K-K, dans laquelle l'élément semiconducteur est monté sur la carte de base avec sa face active tournée vers la face avant de la carte de base ;
- la FIG.4E est une vue similaire à celles des FIG.4C et D, en coupe selon H-H.

Les besoins en circuits intégrés travaillant à des fréquences toujours plus élevées, nécessitent de résoudre les problèmes liés à l'encapsulation de ces circuits. En effet, dans des circuits intégrés monolithiques, où certains sous-ensembles ont des fréquences de travail aussi élevées que de 10-120 GHz, il apparaît des problèmes qui ne se posent pas dans l'état de la technique cité où les fréquences de travail étaient de 2 GHz.

D'une manière générale, les problèmes dans le domaine de fréquences élevées envisagées sont liés aux imperfections de connexions qui créent des discontinuités de masse, ou des discontinuités dans le mode de propagation des ondes, et qui limitent donc les fréquences de travail à des valeurs inférieures à celles qui sont envisagées.

Pour minimiser ces problèmes de connexion, est apparu le besoin d'intégrer de façon monolithique plusieurs sous-ensembles d'un circuit sur un même puce. Ces sous-ensembles travaillent à des fréquences différentes, parfois sous des alimentations continues différentes, et sont réalisés au moyen de technologies différentes.

L'invention propose des moyens pour réaliser les circuits monolithiques qui permettent d'obtenir un gain de surface sur le substrat, et qui tiennent compte des problèmes particuliers au domaine des hyperfréquences, c'est-à-dire les limitations en fréquences dues aux connexions, les difficultés liées aux différences de technologies de réalisation des sous-ensembles, et les problèmes d'encapsulation.

Selon l'invention, dans un dispositif semiconducteur hyperfréquences, on prévoit :
- un élément semiconducteur 1 du type "FLIP-CHIP", lequel comprend un substrat semiconducteur dont une face dite active la a un circuit intégré 200 avec au moins un élément actif T et une pluralité de plots métalliques d'entrées-sorties, 101a, 102a, 301a, 202a,
- une carte de base 2, laquelle comprend un substrat isolant dont une face dite avant 2a a une pluralité de plots métalliques d'entrées-sorties 101c, 102c, 301c, 202c,
- et des moyens de fixation de la face active 1a de l'élément semiconducteur sur la face avant 2a de la carte de base, avec les plots correspondants d'entrées-sorties en contact électrique, respectivement 101a-101c ; 102a-102c ; 301a-301c ; 202a-202c ;
et on prévoit en outre que :
- l'élément semiconducteur 1 comprend, d'une part un circuit 200, 300 de lignes de transmission du type coplanaire L1, L2, L3, ℓ dont les rubans conducteurs et les métallisations de masse M11, M12 sont disposés, avec le ou les éléments actifs, sur la face active 1a, et d'autre part un circuit 100 de lignes de transmission du type microruban 110, 111, 112, 113, dont les rubans conducteurs sont disposés sur la face opposée 1b à la face active, et dont les métallisations de masse M11, M12 sont constituées par celles de la face active 1a,
- la carte de base comprend en outre sur sa face avant 2a des métallisations de masse M13 dessinées de manière à être en contact électrique avec les métallisations de masse M11, M12 de la face active 1a de l'élément semiconducteur 1 lors de la fixation de ce dernier sur la carte de base 2.

### Exemple de mise en oeuvre

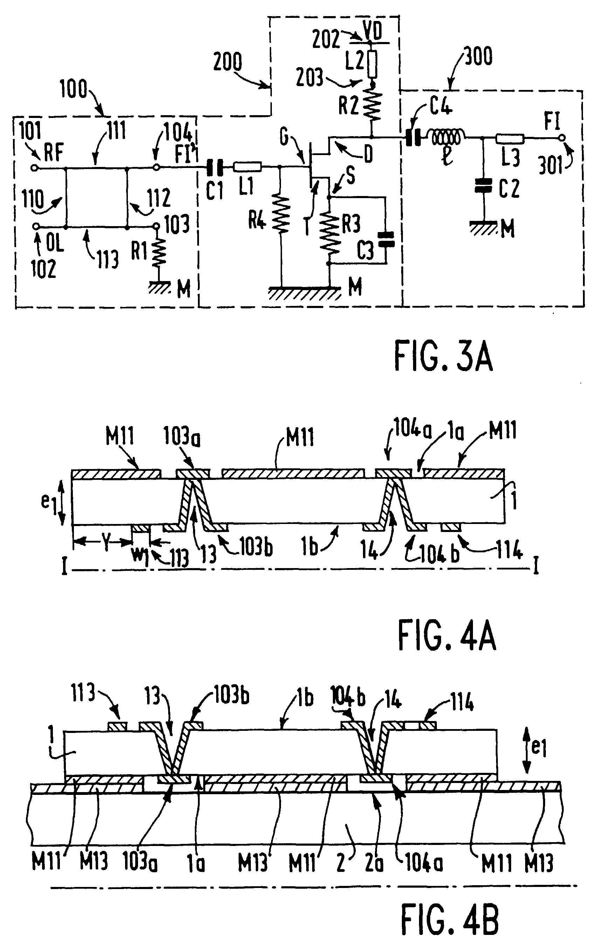

Dans des modules récepteurs d' antenne pour la réception d'émissions provenant d'un satellite artificiel, fonctionnant dans la bande 11,7 à 12,2 GHz, on peut être amené à réaliser un circuit du type de celui représenté sur la FIG.3A. Ce circuit est un mélangeur simple, à deux entrées 101, 102, l'une 101 pour le signal radiofréquences RF, l'autre 102 pour le signal d'un oscillateur local OL, et à une sortie 301 à la fréquence intermédiaire FI = RF-OL . Ce circuit comprend un premier sous-ensemble 100 purement passif, formant un coupleur à branches 0-90°, muni de deux entrées 101, 102 pour les deux signaux alternatifs à mélanger RF et LO, et d'une sortie 104 pour un signal mélangé FI'. Ce sous-ensemble 100 est uniquement constitué de lignes de transmission 110, 111, 112, 113. Le circuit mélangeur de la FIG.3A comprend aussi un second sous-ensemble 200 actif formé d'au moins un transistor T et d'éléments résistifs R2, R3, R4, capacitifs C1, C3 et d'inductances L2 pour optimiser le signal fourni par la sortie 104 du coupleur à branches 100.

A la fréquence de travail du coupleur à branche, c'est-à-dire 12 GHz, correspondant à une longueur d'onde guidée de 9 mm, la longueur des branches 110, 111, 112, 113 du coupleur est de l'ordre de 2,5 mm. Ce sous-ensemble passif 100 est donc très consommateur de surface. De plus, il est beaucoup plus sensible aux perturbations dues aux défauts de structure que le second sous-ensemble actif 200. Jusqu'à ce jour, pour ces raisons, il était généralement connu de réaliser les différents sous-ensembles hyperfréquences sur des puces différentes. Ainsi, une "tête de réception d'antenne" complète pouvait comprendre jusqu'à 5 à 6 puces différentes. On retrouvait alors les problèmes de connexions hyperfréquences et de masse de ces diverses puces entre elles. D'où la nécessité d'intégrer le plus grand nombre possible de sous-ensembles de circuits sur une même puce, principalement parmi les sous-ensembles qui travaillent aux fréquences les plus élevées.

Le problème réside alors dans les dimensions des substrats semiconducteurs pour hyperfréquences disponibles sur le marché, et dans leurs coûts. Les applications grand public requièrent des coûts faibles et donc impliquent la réalisation d'un maximum d'éléments par unité de surface de substrat, c'est-à-dire le maximum de sous-ensembles par puce de surface standard.

En référence avec la FIG.3A, dans le circuit actif 200, le signal de sortie FI' est appliqué sur la grille G du transistor T qui est polarisé de manière à fournir sur la sortie 301, le signal FI à la fréquence intermédiaire RF-OL. Ces moyens de polarisation comprennent :
- une polarisation de la grille G par rapport à la masse incluant par exemple une ligne L1 et une résistance R4,
- une polarisation de la source S par rapport à la masse incluant par exemple une résistance R3 et une capacité C3,
- une polarisation du drain D par rapport à une alimentation continue VD incluant par exemple une résistance R2 et une ligne L2.

Puis le circuit mélangeur de la FIG.3A comprend un filtre passif 300 qui inclut par exemple une self inductance ℓ, une capacité C2 et une ligne L3.

Les divers sous-ensembles 100, 200, 300 sont reliés à travers des capacités d'isolation C1,C4.

Ces divers sous-ensembles doivent être réalisés de manière monolithique sur un substrat semiconducteur, lequel doit être muni de moyens d'encapsulation.

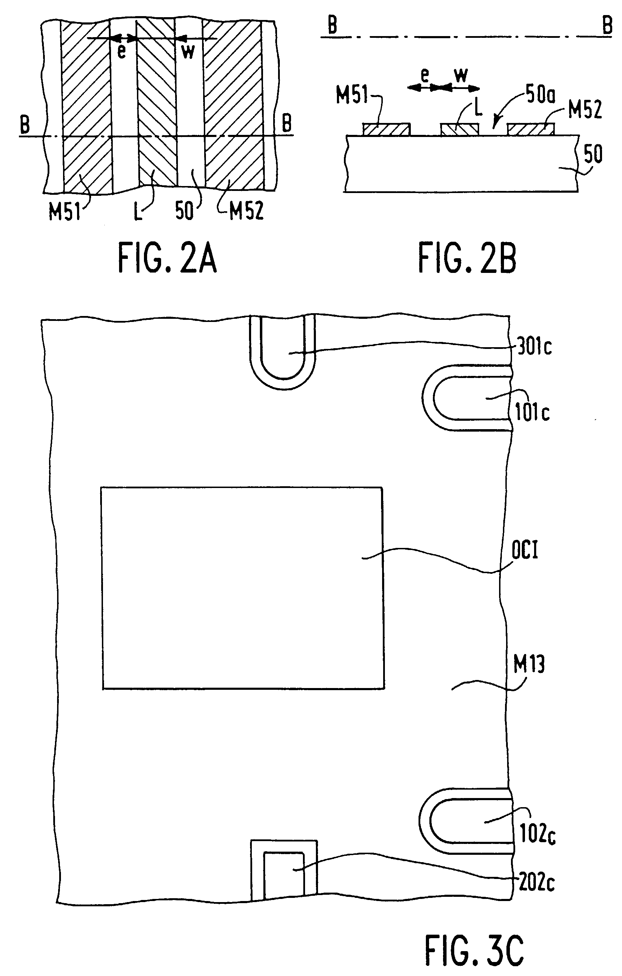

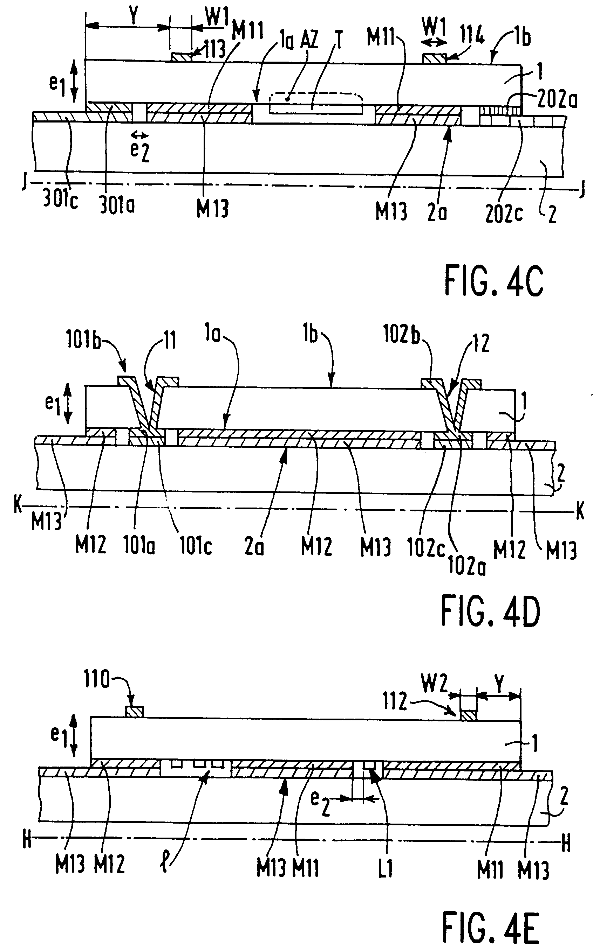

En référence avec les FIG.3B, 3C et avec l'ensemble des figures 4, un dispositif semiconducteur pour recevoir un tel circuit formé de sous-ensembles monolithiquement intégrés comprend les éléments principaux suivants :
- un élément semiconducteur 1 formé d'un substrat avec une face active la portant le circuit intégré 200, 300 hyperfréquences, et ayant une pluralité de plots métalliques hyperfréquences d'entrées-sorties 101a, 102a, 301a, des métallisations de masse M11, M12, et un plot d'alimentation continue VD 202a,
- une carte de base 2 formée d'un substrat avec une face avant 2a support pour l'élément semiconducteur 1, cette face avant portant une pluralité de plots métalliques hyperfréquences 101c, 102c, 301c correspondant aux plots hyperfréquences d'entrées-sorties 101a, 102a, 301a du circuit intégré, et un plot d'alimentation continue VD 202c,
- et des moyens de scellement de l'élément semiconducteur 1 par sa face active 1a sur la face support 2a de la carte de base 2, avec connexion électrique des conducteurs correspondants.

Selon l'invention, on prend en compte qu'en hyperfréquences un circuit intégré tel que le circuit 200, 300 de la FIG.3A nécessite la réalisation de lignes de transmission L1, L2, L3 et de self-inductances ℓ, et que, d'une manière générale, dans ce domaine de fréquences tous les conducteurs de signaux alternatifs doivent avoir la structure d'une ligne de transmission.

Selon l'invention, sur la face active 1a de l'élément semiconducteur, les lignes de transmission L1, L2, L3 et self inductances ℓ associées au circuit actif sont réalisées en technologie coplanaire.

En référence avec les FIG.2A et 2B, les circuits réalisés en technologie coplanaire comportent un substrat 50 diélectrique ou semi-isolant, et les lignes de transmission sont réalisées sur une face de ce substrat, dite face avant 50a au moyen de rubans conducteurs L, de largeur W, disposés à une distance e de métallisations de masse M51, M52. Chaque ligne peut comporter une seule métallisation de masse à la distance e, ou bien deux métallisations de masse a la distance e entourant le conducteur central L. Le mode de propagation hyperfréquences dans la ligne ainsi formée est une fonction de cet assemblage coplanaire ; et l'impédance caractéristique de la ligne prend en compte la dimension W du conducteur central, la distance e et la perméabilité et la constante diélectrique (respectivement µ et ε) du substrat 50 entre le conducteur L et la métallisation de masse M51, M52.

En référence avec la FIG.3B, on applique cette technologie coplanaire à la réalisation, sur la face active 1a de l'élément semiconducteur 1, en plus du ou des transistors T et éléments de polarisation résistifs R2, R3, R4 et capacitifs C1, C2, C3, C4, des éléments de lignes et de selfs-inductances, tels que les éléments L1, L2, L3 et ℓ du circuit de la FIG.3A.

La FIG.3B montre en vue plane, la face active 1a d'un élément semiconducteur 1 munie, en trait plein, des sous-ensembles de circuit intégré 200 et de filtre 300 correspondant au circuit schématique de la FIG.3A.

La disposition des éléments représentés sur la FIG.3B est donnée tout à fait à titre d'exemple, de même que l'agencement du circuit de la FIG.3A. Cette représentation des éléments actifs, résistifs et capacitifs et selfiques enseigne que les métallisations de masse M11, M12 des lignes de transmission L1, L2, L3 et self-inductance ℓ couvrent sensiblement toute la surface de la face active 1a laissée libre par ces éléments, ceci en ménageant la distance e2 entre les conducteurs hyperfréquences et les métallisations de masse M11, M12 conformément aux règles de propagation hyperfréquences.

On reconnaît sur la FIG.3B, les éléments des sous-ensembles 200, 300 du circuit de la FIG.3A :
- Pour le sous-ensemble 200, le transistor T avec sa source S, son drain D, sa grille G ; les lignes L1,L2 ; les résistances R2, R3 et R4 : et les capacités C1 et C3 ;
- Pour le sous-ensemble 300, les capacités C2 et C4 : la self inductance ℓ et la ligne L3.

La face active 1a est en outre munie d'un plot métallique 301a pour la sortie FI du mélangeur,
- d'un plot métallique 104a pour l'entrée FI' correspondant à la sortie du coupleur 100 et à l'entrée du sous-ensemble 200,
- d'un plot métallique 202a pour l'application de la tension d'alimentation continue VD du circuit actif 200.

Selon l'invention, les moyens pour gagner une surface de substrat appréciable dans la réalisation du dispositif intégré monolithique consistent à réaliser les sous-ensembles passifs tel que 100, constitués principalement de lignes de transmission telles que 110, 111, 112, 113, sur la face opposée 1b du substrat 1, par rapport à la face active 1a. Ces sous-ensembles de la face non-active 1b sont réalisés en technologie microruban et utilisent comme plans de masse, les plans de masse M11, M12 des lignes coplanaires de la face active.

Ainsi, dans le circuit mélangeur de la FIG.3B décrit à titre d'exemple, on réalisera le sous-ensemble 100 sur la face 1b dite non-active du substrat 1. A cet effet les tronçons de ligne 110, 111, 112, 113 sont réalisés en technologie dite microruban.

Donc, sur cette face non active 1b on trouve exclusivement des rubans métallisés ; alors que sur la face active, on trouvait des éléments actifs T réalisés dans des zones actives AZ formées dans le substrat par épitaxie ou implantations, des ponts à air AB et des rubans métallisés pour former les lignes ; ainsi que les résistances et capacités ayant plusieurs niveaux de dépôts.

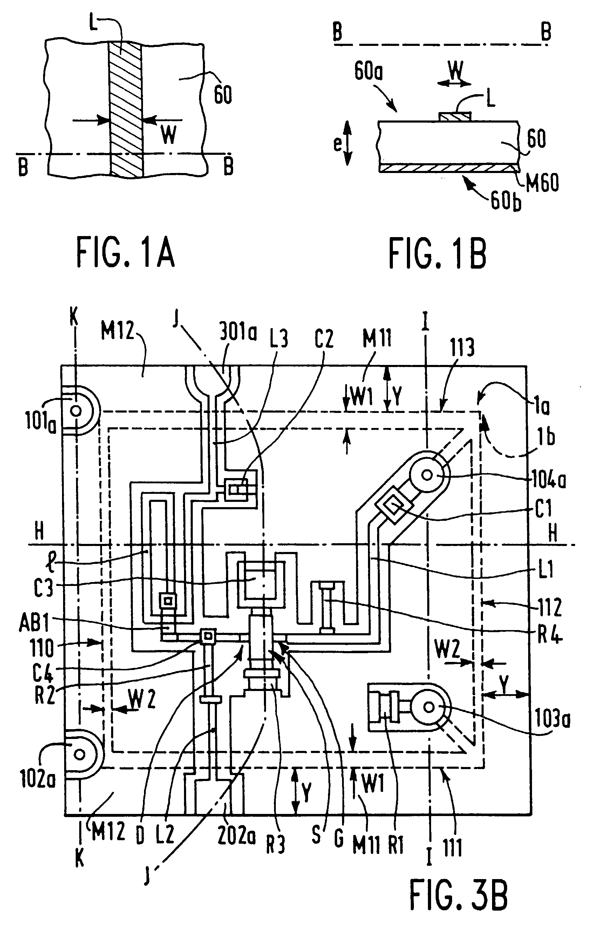

En référence avec les FIG.1A et 1B, les circuits réalisés en technologie microruban comportent un substrat 60 diélectrique ou semi-isolant, d'épaisseur e donnée ; et les lignes de transmission hyperfréquences comportent sur la face avant 60a du substrat 60, des conducteurs L en forme de ruban de largeur W, et sur la face arrière 60b du substrat 60, un plan de masse M60. Le mode de propagation dans ces lignes microrubans est une fonction de la dimension W du conducteur supérieur, de l'épaisseur e et des perméabilités et constante diélectrique µ et ε respectivement du substrat 60 placé entre le conducteur L et la métallisation de masse M60.

En référence avec la FIG.3B, on a représenté à titre d'exemple, en trait pointillé, un mode de réalisation du coupleur 100 disposé sur la face non-active 1b. Dans cet exemple, ce coupleur 100 comprend quatre conducteurs microrubans 110, 111, 112, 113 : un plot métallique 101b pour l'entrée du signal RF, un plot métallique 102b pour l'entrée du signal OL, un plot métallique 104b pour la sortie du signal FI', et un plot métallique 103b pour la connexion à une résistance R3 qui relie ce plot à la masse.

Les lignes 110, 111, 112, 113 sont réparties en quatre branches formant une figure quadrangulaire. Les entrées sont appliquées à l'extrémité 101b, 102b des deux lignes parallèles 111 et 113 respectivement, et la sortie FI' alternative est disponible à l'extrémité 104b d'une de ces lignes par exemple 111 (si l'autre extrémité 101b est connectée à RF). L'extrémité de la ligne 113 opposée à OL est alors connectée à la masse à travers une résistance R1 au moyen d'un plot métallique 103b. La résistance R1 ayant plusieurs niveaux de dépôt, est elle-même réalisée sur la face active 1a.

Les lignes 110, 111, 112, 113 de la face 1b opposée à la face active qui sont du type microruban, utilisent les plans de masse M11, M12 réalisés sur la face active 1a, qui sont aussi les plans de masse des lignes coplanaires L1, L2, L3, et ℓ de la face active.

Ainsi, des sous-ensembles de grande surface tels que le sous-ensemble hyperfréquence passif 100 est réalisé monolithiquement avec les sous-ensembles 200, 300, avec une économie de la moitié de la surface de substrat qui aurait été nécessaire si l'on avait utilisé la technologie connue de l'état de la technique. De plus, les problèmes de raccordement de masse sont évités puisque les masses sont les mêmes pour tous les sous-ensembles. La technologie de réalisation du sous-ensemble 100 sur cette face opposée 1b ne pose pas de problèmes puisque les lignes qui le constituent sont de simples rubans métalliques. Tous les éléments faisant appel à une technologie plus complexe (éléments actifs, résistances, capacités, ponts à air) sont réalisés de manière conventionnelle sur la face active 1a.

Pour transférer les signaux hyperfréquences de la face non-active 1b, à la face active 1a, sans voir apparaître de capacités parasites conséquentes, on utilise une technique de trous métallisés ou bien de piliers métalliques.

En référence avec les FIG.4A, 4B, 4C, 4D, 4E qui sont des coupes des figures 3B, 3C, selon différentes lignes I-I, J-J, K-K, H-H, les signaux hyperfréquences sont transférés par des trous métallisés ou des piliers métalliques. Ainsi les trous métallisés 11, 12, 13, 14 joignent respectivement les plots hyperfréquences 101a-101b ; 102a-102b ; 103a-103b ; 104a-104b, à travers le substrat de l'élément semiconducteur.

Ensuite, selon l'invention, les moyens pour réaliser la connexion électrique des conducteurs correspondants de l'élément semiconducteur et de la carte de base, et pour permettre le scellement de l'élément semiconducteur sur la face support de la carte de base dans des conditions appropriées au fonctionnement aux hyperfréquences envisagés (10 à 120 GHz), comprennent les caractéristiques suivantes :
- En référence avec la figure 3B, l'élément semiconducteur 1 comprend donc les plots de contact hyperfréquences 101a, 102a, 301a et les plans de masse M11, M12 réalisés sur la face active la de son substrat, lequel est favorablement semi-isolant pour la réalisation appropriée de l'élément actif T ; et cette face active 1a comprend en outre le plot 202a pour recevoir l'alimentation continue VD ;
- En référence avec la FIG. 3C, la carte de base 2 comprend sur sa face support 2a un plan de masse M13 disposé, avec les plots hyperfréquences 101c, 102c, 301c et le plot d'alimentation continue 202c, selon un dessin tel que ces plots et plans de masse coïncident et soient en contact électrique respectivement avec les plots et plans de masse de la face active 1a lorsque l'élément semiconducteur est "retourné" sur la carte de base.

Ainsi le plan de masse M13 de la face 2a de la carte de base coïncide avec les plans de masse M11, M12 de la face active la de l'élément semiconducteur 1, et permet de faire une liaison de masse parfaite ; les plots hyperfréquences 101a-101c ; 102a-102c : 301a-301c coïncident ; et les plots de tension continue VD 202a-202c coïncident.

Les moyens de liaison pour fixer la face active 1a de l'élément semiconducteur sur la face avant 2a de la carte de base peuvent être tout moyen de soudure ou collage conducteur connu de l'homme du métier des circuits intégrés hyperfréquences.

L'élément semiconducteur 1 est donc scellé par un de ces moyens sur la carte de base dans cette position de coïncidence permettant la connexion électrique directe.

La FIG.4A est une coupe de la figure 3B, selon I-I. Dans cette figure, on a représenté la face active 1a comme face supérieure de l'élément semiconducteur 1. On reconnaît sur cette face active 1a, les plans de masse M11 et les plots hyperfréquences 103a, 104a ; on reconnaît ensuite sur la face inférieure non active 1b, les lignes hyperfréquences microrubans 113, 114 qui ont comme plans de masse M11 ; on reconnaît également les plots hyperfréquences 103b, 104b reliés aux plots 103a, 104a de la face active par les trous métallisés 13 et 14 respectivement.

La FIG.4B est une coupe des FIG.3B-3C selon I-I. Dans cette FIG.4B, l'élément semiconducteur 1 est "retourné", pour que sa face active 1a vienne s'appliquer sur la face avant 2a de la carte de base 2. La face non active 1b est maintenant la face supérieure du dispositif semiconducteur formé par le scellement de l'élément 1 sur la carte 2. Il en résulte que les lignes 110, 111, 112, 113 hyperfréquences, dans lesquelles se fait la majeure partie de la propagation, ne subissent pas d'influence néfaste. Dans cette FIG.4B, on reconnaît les masses M11 et M13 de la face active 1a et de la face avant 2a en coïncidence. Par contre, les plots hyperfréquences 103a et 104a, qui ne sont pas des entrées-sorties sont en regard d'une couche d'air comme diélectrique, de préférence.

Les FIG. 4C, 4D, 4E sont des coupes avec également l'élément semiconducteur 1 "retourné" sur la carte 2. Dans la FIG.4C, en coupe selon J-J, on reconnaît, sur la face 1b maintenant supérieure du dispositif, les lignes microrubans 113 et 114 de largeur W1, ayant pour plan de masse M11 situé sur la face active 1a, à la distance e1, correspondant à l'épaisseur du substrat de l'élément semiconducteur. Dans l'assemblage de l'élément 1 sur la carte 2, les masses M11 et M13 coïncident. On reconnaît le transistor T réalisé dans une zone active AZ du substrat semiconducteur, qui peut être en outre diposé vis-à-vis d'un évidement OCI formé dans la face avant 2a de la carte de base. De tels évidements peuvent également être formés dans la face avant de la carte de base en vis-à-vis de chaque ligne ou plot hyperfréquence non connecté, tel que L1, ℓ, ou 103a, 104a. Dans la FIG.4C on reconnaît également le plot hyperfréquence 301a de la face active 1a en coïncidence avec le plot hyperfréquence 301c de la carte de base.

En référence avec la FIG.3C qui montre la carte de base vue du dessus, le plot ou ligne hyperfréquence de sortie 301c est réalisé en technologie coplanaire (voir les FIG.2A, 2B), ainsi que les plots ou lignes hyperfréquences d'entrée 101c, 102c. A cet effet, les rubans formant ces lignes sont espacés des plans de masse M11, M12, M13 d'une distance e2.

Dans la FIG.4C, on reconnaît également le plot d'alimentation continue VD 202a de la face active 1a en coïncidence avec le plot ou ligne de tension continue 202c de la carte 2.

Dans la FIG.4D, en coupe selon K-K, on reconnaît le plan de masse M12 de la face active 1a en coïncidence avec le plan de masse M13 de la face avant 2a. On reconnaît également les plots d'entrées hyperfréquences 101b, 102b réalisés sur la face non active 1b, reliés aux plots d'entrées hyperfréquences 101a, 102a de la face active 1a, par les trous métallisés 11 et 12. Les plots hyperfréquences d'entrées 101a, 102a sont en coïncidence avec les plots ou lignes hyperfréquences 101c, 102c de la face avant de la carte de base.

Dans la FIG.4E, on reconnaît les lignes hyperfréquences 110, 112, de largeur W2, réalisées en technologie microruban sur la face non active 1b, ayant comme plans de masse M11, M12 réalisés sur la face active 1a. On reconnaît également les lignes L1 et ℓ réalisées sur la face active 1a, en technologie coplanaire ayant ces mêmes plans de masse M11, M12. Les lignes L1, ou ℓ sont séparées des plans de masse coplanaires par une distance e2. Sur la FIG.4E, on reconnaît les plans de masse M11, M12 en coïncidence avec le plan de masse M13 de la carte de base. Les lignes L1, et ℓ sont en vis-à-vis d'une couche d'air.

Eventuellement, des éléments passifs de grandes dimensions, par exemple des capacités de découplage, peuvent être fixés sur la carte de base, laquelle peut aussi comprendre un circuit de lignes coplanaires plus complexe que celui de la FIG.3C.

Notamment, une capacité de découplage peut être ainsi fournie entre le noeud 203 et la masse du circuit de la FIG.3A.

Dans un exemple de réalisation du circuit de la FIG.3A conformément à la description précédente, les dimensions, pour le fonctionnement à 12 GHz peuvent être les suivantes :
Epaisseur du substrat e1 = 100 µm
Largeur des lignes 111, 113, W1 = 150 µm
Longueur des lignes 111, 113 = 2120 µm
Largeur des lignes 110, 112, W2 = 75 µm
Longueur des lignes 110, 112 = 2170 µm
Distance Y d'une ligne au bord de la masse M11, M12 sous-jacente = supérieure à la largeur de la ligne concernée.
Dimension d'un trou métallisé 11, 12, 13 ou 14 sur la face non-active 1b = 100 µm environ.
Valeur des éléments de circuit :
   R1 = 50 Ω
   R2 = 100 Ω (résistance de polarisation)
   R3 = 300 Ω (résistance d'autopolarisation)
   R4 = 1000 Ω (résistance d'autopolarisation)
   C1 = 5 pF (capacité de liaison en entrée)
   C2 = 1 pF (capacité de filtrage du signal OL)
   C3 = 10 pF (capacité de découplage en hyperfréquences de la résistance R3)
   C4 = 5pF (capacité de liaison en sortie)
   L1, L2, L3 = lignes hyperfréquences à haute impédance caractéristique, Zc = 90 Ω.

L'impédance de ces lignes hyperfréquences L1, L2, L3 est caractérisée par le rapport W/W+2(e2), où W est la largeur du ruban de ces lignes et e2 est la distance avec le plan de masse voisin M11, M12. Dans le cas choisi comme exemple, e2 = 100 µm.

Ce rapport, combiné avec l'épaisseur du substrat, e1 = 100 µm, et avec la permitivité relative de ce substrat, ε r = 12,8, si le substrat est en arséniure de gallium (GaAs), permet d'obtenir l'impédance caractéristique des lignes hyperfréquences de type coplanaire.

Il en résulte que :
la longueur de la ligne L1 = 1,5 mm
la longueur de la ligne L2 = 0,5 mm
la longueur de la ligne L3 = 0,5 mm

Dans l'exemple du circuit de la FIG.3A, on trouve aussi un élément dit "localisé" constitué par la self inductance ℓ du type "enroulé" avec un changement de niveau par un pont à air AB. Cette inductance enroulée a pour largeur 5 µm, avec un espace interspiré de 10 µm.

L'adaptation à 50 Ω de l'accès FI est donc réalisé par cette inductance (associée à la capacité C2) de valeur 4nH.

## Revendications

1. Dispositif semiconducteur hyperfréquences comportant :
- un élément semiconducteur du type "FLIP-CHIP", lequel comprend un substrat (1) semiconducteur dont une face dite active (1a) a au moins un circuit intégré (200) et une pluralité de plots métalliques d'entrées-sorties (101a, 102a, 202a, 301A),
- une carte de base (2), laquelle comprend un substrat isolant dont une face dite avant (2a) a une pluralité de plots métalliques d'entrées-sorties (101c, 102c, 202c, 301c),,
- et des moyens de fixation de la face active de l'élément semiconducteur sur la face avant de la carte de base, avec les plots correspondants d'entrées-sorties en contact électrique,
**caractérisé en ce que,**
- l'élément semiconducteur comprend, d'une part un circuit de lignes de transmission du type coplanaire (L1, L2, L3, ℓ) dont les rubans conducteurs et les métallisations de masse sont disposés sur la face active (1a), et d'autre part un circuit de lignes de transmission du type microruban (110, 111, 112, 113), dont les rubans conducteurs sont disposés sur la face opposée (1b) à la face active, et dont les métallisations de masse (M11, M12) sont constituées par celles de la face active,
- la carte de base comprend en outre des métallisations de masse (M13) dessinées de manière à être en contact électrique avec les métallisations de masse de la face active (1a) de l'élément semiconducteur lors de la fixation de ce dernier sur la carte de base.

2. Dispositif semiconducteur selon la revendication 1, **caractérisé en ce que** l'élément semiconducteur a aussi des trous métallisés (11, 12, 13, 14) pour connecter les circuits et/ou plots de la face active avec le circuit de la face opposée.

3. Dispositif semiconducteur selon l'une des revendications 1 ou 2, **caractérisé en ce que** le circuit intégré de la face active de l'élément semiconducteur comprend des éléments actifs (T).

4. Dispositif semiconducteur selon l'une des revendications 1 à 3, **caractérisé en ce que** le circuit intégré de la face active de l'élément semiconducteur comprend des éléments résistifs (R1, R2, R3, R4) et/ou capacitifs (C1, C2, C3), et inductifs (L1, L2, L3, ℓ).

5. Dispositif selon l'une des revendications précédentes, **caractérisé en ce que** sur la face active (1a) de l'élément semiconducteur (1), les métallisations de masse (M11, M12) occupent toute la surface libre en dehors des conducteurs, et des éléments actifs, résistifs et/ou capacitifs, et inductifs, et en ce que, sur la face avant (2a) de la carte de base (2), les métallisations de masse (M13) occupent au moins une surface identique en regard, dans la mesure où les lois relatives aux technologies de circuits sont respectées.

6. Dispositif selon l'une des revendications précédentes, **caractérisé en ce que** la face avant (2a) de la carte de base (2) comprend un circuit de pistes métallisées raccordées aux plots métalliques d'entrées-sorties (101c, 102c, 301c).

7. Dispositif selon la revendication 6, **caractérisé en ce que** des composants discrets sont connectés au circuit de pistes métallisées de la carte de base.

8. Dispositif selon la revendication 7, **caractérisé en ce que** certains de ces composants discrets sont par ailleurs connectés à des éléments de circuit de la face opposée à la face active de l'élément semiconducteur.

9. Dispositif selon l'une des revendications précédentes, **caractérisé en ce que** la carte de base comprend une cavité (OCI) en regard des éléments actifs de la région du circuit intégré de la face active de l'élément semiconducteur, cette cavité étant réalisée entre les métallisations de masse et plots d'entrées-sorties.

10. Dispositif selon l'une des revendications précédentes, caractérisé en ce que le circuit de lignes microrubans disposé sur la face opposée à la face active de l'élément semiconducteur, est un circuit déphaseur générant des signaux déphasés de 90° ou 180°.

## Patentansprüche

1. Hyperfrequenz-Halbleiteranordnung mit:
- einem Halbleiterelement des "Flip-Chip-Typs", das ein Halbleitersubstrat (1) umfaßt, bei dem eine sogenannte aktive Fläche (1a) wenigstens eine integrierte Schaltung (200) und eine Mehrzahl von metallischen Ein/Ausgangssteckern (101a, 102a, 202a, 301A) umfaßt,
- einer Basiskarte (2), die ein isolierendes Substrat umfaßt, bei der eine sogenannte vordere Fläche (2a) eine Mehrzahl von metallischen Ein/Ausgangssteckern (101c, 102c, 202c, 301c) umfaßt,
- und Mitteln zur Befestigung der aktiven Fläche des Halbleiterelements auf der vorderen Fläche der Basiskarte mit den entsprechenden Ein/Ausgangssteckern in elektrischem Kontakt,
dadurch gekennzeichnet, daß
- das Halbleiterelement erstens eine Übertragungsleitungsschaltung vom koplanaren Typ (L1, L2, L3, ℓ) umfaßt, bei der die Leiterstreifen und die Massemetallisierungen auf der aktiven Fläche (1a) angeordnet sind, und zweitens eine Übertragungsleitungsschaltung des Microstrip-Typs (110, 111, 112, 113) umfaßt, bei der die Leiterstreifen auf der der aktiven Fläche gegenüberliegenden Fläche (1b) angebracht sind, und deren Massemetallisierungen (M11, M12) aus denen der aktiven Fläche bestehen,
- die Basiskarte außerdem Massemetallisierungen (M13) umfaßt, die so entworfen sind, daß sie in elektrischem Kontakt mit den Massemetallisierungen der aktiven Fläche (1a) des Halbleiterelements bei der Befestigung dieses letzteren auf der Basiskarte stehen.

2. Halbleiteranordnung nach Anspruch 1, dadurch gekennzeichnet, daß das Halbleiterelement auch metallisierte Löcher (11, 12, 13, 14) hat, um die Schaltungen und/oder Stecker der aktiven Fläche mit der Schaltung der gegenüberliegenden Fläche zu verbinden.

3. Halbleiteranordnung nach einem der Ansprüche 1 oder 2, dadurch gekennzeichnet, daß die integrierte Schaltung der aktiven Fläche des Halbleiterelements aktive Elemente (T) umfaßt.

4. Halbleiteranordnung nach einem der Ansprüche 1 bis 3, dadurch gekennzeichnet, daß die integrierte Schaltung der aktiven Fläche des Halbleiterelements Widerstands (R1 R2, R3, R4) und/oder Kapazitäts- (C1, C2, C3) und Induktivitätselemente (L1, L2, L3, ℓ) umfaßt.

5. Anordnung nach einem der vorstehenden Ansprüche, dadurch gekennzeichnet, daß die Massemetallisierungen (M11, M12) auf der aktiven Fläche (1a) des Halbleiterelements (1) die gesamte freie Oberfläche außerhalb der Leiter und der aktiven, Widerstands- und/oder Kapazitäts und Induktivitätselemente einnehmen, und daß die Massemetallisierungen (M13) auf der vorderen Fläche (2a) der Basiskarte (2) wenigstens eine identische Oberfläche gegenüber einnehmen, soweit die Gesetze bezüglich der Schaltkreistechnik eingehalten werden.

6. Anordnung nach einem der vorstehenden Ansprüche, dadurch gekennzeichnet, daß die vordere Fläche (2a) der Basiskarte (2) eine Schaltung mit metallisierten Spuren umfaßt, die mit den metallischen Ein/Ausgangssteckern (101c, 102c, 301c) verbunden sind.

7. Anordnung nach Anspruch 6, dadurch gekennzeichnet, daß die diskreten Komponenten mit der Schaltung mit metallisierten Spuren der Basiskarte verbunden sind.

8. Anordnung nach Anspruch 7, dadurch gekennzeichnet, daß bestimmte dieser diskreten Komponenten außerdem mit Schaltungselementen der Fläche verbunden sind, die der aktiven Fläche des Halbleiterelements gegenüberliegt.

9. Anordnung nach einem der vorstehenden Ansprüche, dadurch gekennzeichnet, daß die Basiskarte eine Aushöhlung (OCI) gegenüber von den aktiven Elementen des Bereich der integrierten Schaltung der aktiven Fläche des Halbleiterelements umfaßt, wobei diese Aushöhlung zwischen den Massemetallisierungen und Ein/Ausgangssteckern realisiert ist.

10. Anordnung nach einem der vorstehenden Ansprüche, dadurch gekennzeichnet, daß die auf der der aktiven Fläche des Halbleiterelements gegenüberliegenden Fläche angebrachte Microstrip-Leitungsschaltung eine Phasenverschiebungsschaltung ist, die um 90° ode 180° phasenverschobene Signale erzeugt.

## Claims

1. A semiconductor device for microwave ranges comprising:
- a semiconductor element of the "flip chip" type which comprises a semiconductor substrate (1) of which an active surface (10) has at least one integrated circuit (200) and a plurality of metal input-output pads (101a, 102a, 202a, 301a),
- a base plate (2) which comprises an insulating substrate of which a front surface (2a) has a plurality of metal input-output pads (101c, 102c, 202c, 301c),
- and means for fixation of the active surface of the semiconductor element on the front surface of the base plate, with the corresponding input-output pads in electrical contact with one another,
characterized in that
- the semiconductor element comprises on the one hand a circuit of transmission lines of the coplanar type (L1, L2, L3, 1) whose conductor strips and ground metallizations are disposed on the active surface (1a), and on the other hand a circuit of transmission lines of the microstrip type (110, 111, 112, 113) whose conductor strips are disposed on the surface (1b) opposed to the active surface and whose ground metallizations (M11, M12) are formed by those of the active surface,
- the base plate in addition comprises ground metallizations (M13) patterned so as to be in electrical contact with the ground metallizations of the active surface (1a) of the semiconductor element upon the fixation of the latter on the base plate.

2. A semiconductor device as claimed in Claim 1, characterized in that the semiconductor element in addition comprises metallized holes (11, 12, 13, 14) for connecting the circuits and/or contact pads of the active surface to the circuit of the opposed surface.

3. A semiconductor device as claimed in Claim 1 or 2, characterized in that the integrated circuit forming part of the active surface of the semiconductor element comprises active elements (T).

4. A semiconductor device as claimed in any one of the Claims 1 to 3, characterized in that the integrated circuit forming part of the active surface of the semiconductor element comprises resistance elements (R1, R2, R3, R4) and/or capacitor elements (C1, C2, C3) and inductance elements (L1, L2, L3 1).

5. A semiconductor device as claimed in any one of the preceding Claims, characterized in that the ground metallizations (M11, M12) on the active surface (la) of the semiconductor element (1) occupy the entire free surface area outside the conductors and outside the active elements, resistors and/or capacitors and inductances, and in that the ground metallizations (M13) on the front surface (2a) of the base plate (2) occupy at least an identical surface area opposite thereto, to the extent to which compliance with the laws relating to the circuit technologies allows.

6. A device as claimed in any one of the preceding Claims, characterized in that the front surface (2a) of the base plate (2) comprises a circuit of metallized tracks connected to metal input-output pads (101c, 102c, 301c).

7. A device as claimed in Claim 6, characterized in that discrete components are connected to the circuit of metallized tracks of the base plate.

8. A device as claimed in Claim 7, characterized in that some of these discrete components are in addition connected to circuit elements of the surface opposed to the active surface of the semiconductor element.

9. A device as claimed in any one of the preceding Claims, characterized in that the base plate comprises a cavity (OCI) opposite active elements of the region of the integrated circuit on the active surface of the semiconductor element, which cavity is realised between the ground metallizations and input-output pads.

10. A device as claimed in any one of the preceding Claims, characterized in that the circuit of microstrip lines arranged on the surface opposed to the active surface of the semiconductor element is a phase shifting circuit generating signals shifted by 90° or 180°.
